# EUROPÄISCHE PATENTSCHRIFT

(11) **EP 3 242 409 B1**
(45) Veröffentlichungstag und Bekanntmachung des Hinweises auf die Patenterteilung: **13.11.2019**
(21) Anmeldenummer: 17168716.3
(22) Anmeldetag: 28.04.2017
(51) Int. Cl.: H04B 1/3877, H04W 52/52, H03G 3/30, H04W 52/36, H04B 1/04, H04B 1/16, H04B 1/18, H04B 1/3822, H04W 52/08

(54) **SCHALTUNGSANORDNUNG UND VERFAHREN ZUR DÄMPFUNGSKOMPENSATION IN EINER ANTENNENSIGNALVERBINDUNG**
CIRCUIT ASSEMBLY AND METHOD FOR ATTENUATION COMPENSATION IN AN ANTENNA SIGNAL CONNECTION
DISPOSITIF DE CIRCUIT ET PROCÉDÉ DE COMPENSATION D'AMORTISSEMENT DANS UNE CONNEXION DE SIGNAUX D'ANTENNE

(30) Priorität: 03.05.2016 DE 102016108206
(43) Veröffentlichungstag der Anmeldung: 08.11.2017
(73) Patentinhaber: BURY Sp. z o.o., 39-300 Mielec (PL)
(72) Erfinder: Solan, Bülent, 33602 Bielefeld (DE)
(74) Vertreter: Gramm, Lins & Partner Patent- und Rechtsanwälte PartGmbB

(56) Entgegenhaltungen:
- DE-A1-102013 101 590
- US-A- 5 303 395
- US-A- 5 995 813
- US-A1- 2005 170 867
- US-A1- 2013 210 500

## Beschreibung

Die Erfindung betrifft eine Schaltungsanordnung zur Kompensation einer in einer Antennensignalverbindung zwischen einem Mobilfunkendgerät und einer Antenne auftretenden Dämpfung mit mindestens einem Antennensignalverstärker in der Antennensignalverbindung und mit einer Steuereinheit zur Einstellung eines Verstärkungsfaktors, um welchen das durch einen zugeordneten Antennensignalverstärker geführte Antennensignal verstärkt oder gedämpft wird, wobei die Schaltungsanordnung mindestens eine Detektionseinheit zur Erfassung einer Antennensignalleistung des Antennensignals im Signalpfad der Antennensignalverbindung hat.

Die Erfindung betrifft weiterhin ein Verfahren zur Kompensation einer in einer Antennensignalverbindung zwischen einem Mobilfunkendgerät und einer Antenne auftretenden Dämpfung mit Hilfe mindestens eines Signalverstärkers in der Antennensignalverbindung mit dem Schritt des Erfassens einer Antennensignalleistung des Antennensignals im Signalpfad der Antennensignalverbindung.

Bei dem Anschluss eines Mobilfunkendgerätes an eine externe Antenne, wie dies bspw. bei Freisprecheinrichtungen in Kraftfahrzeugen erfolgt, tritt im Signalweg von Mobilfunkendgerät zu Antenne und umgekehrt eine Dämpfung auf. Obwohl durch die externe Antenne die Sende- und Empfangsqualität verbessert werden soll, bewirkt die Dämpfung, dass die maximal mögliche Signalqualität nicht erreicht wird.

Die Dämpfung ist bei einer kabelgebundenen Anbindung des Mobilfunkendgerätes an die Antenne in der Praxis annähernd konstant und ermöglicht den Betrieb einer Kompensationsschaltung mit konstantem Verstärkungsfaktor. Bei einer elektromagnetischen, kapazitiven oder induktiven Kopplung des Mobilfunkendgerätes mit dem Antennensignalverstärker und der daran angeschlossenen Antenne kann die Dämpfung jedoch in Abhängigkeit von dem aktuellen Betriebszustand und dem verwendeten Mobilfunkendgerät variieren. Dann ist ein vorgegebener konstanter Verstärkungsfaktor nicht optimal, um die momentane Dämpfung zu kompensieren. DE 10 2013 101 590 A1 beschreibt eine Schaltungsanordnung zur Kompensation einer Koppeldämpfung in einer Antennensignalverbindung, bei der ein Verstärkungsfaktor in einer gegenüber der Regelgeschwindigkeit eines Antennensignalleistungs-Regelkreises zwischen einem angekoppelten Mobilfunkendgerät und einer Basisstation eines Mobilfunknetzes langsameren Änderungsgeschwindigkeit angepasst wird. Durch die netzseitige Leistungsregelung erfolgt zunächst aber ohnehin eine Anpassung der Signalleistung des Mobilfunkendgerätes an die vorliegende Gesamtdämpfung zwischen Mobilfunkendgerät und Basisstation so, dass die Mobilfunkendgeräte mit der minimalen möglichen (optimalen) Leistung senden. Diese netzseitige Leistungsregelung wird für einen vorgegebenen Grenzbereich durch eine zusätzliche Anpassung des Verstärkungsfaktors unterstützt.

US 5,995,813 A beschreibt einen Verstärker für das Antennensignal eines Mobiltelefons, wobei der Verstärkungsfaktor des Verstärkers unabhängig von dem Verstärkungsfaktor des Mobiltelefons gesteuert wird. Die Differenz des Signalpegels am Eingang und Ausgang des Verstärkers wird überwacht. Wenn die Signalpegel gleich sind wird ein eingestellter Verstärkungsfaktor genutzt und der Verstärker bei Überschreiten eines vorgegebenen Signalpegels einfach ausgeschaltet. Ansonsten wird der Verstärkungsfaktor für den Sendeverstärker nachgeregelt.

US 5,303,395 A offenbart ein System zur Regelung des Sendepegels von Funksignalen eines Mobiltelefons, wobei der Verstärkungsfaktor einer Verstärkerstufe angepasst wird.

US 2013/0210500 A1 beschreibt einen Booster für das Sendesignal eines Mobiltelefons. Ein Leistungsregler schaltet einen Signalpfad zwischen einem Verstärker und einem Verstärker-Bypass entsprechend der erforderlichen Sendeleistung. US 2005/0170867 A1 beschreibt einen Booster, der zwischen ein Mobiltelefon und eine Sende-/Empfangsantenne geschaltet wird. Der Verstärkungsfaktor ist bis zu einer vorgegebenen Maximalverstärkung linear von der Eingangssignalleistung abhängig.

Ausgehend hiervon ist es Aufgabe der vorliegenden Erfindung, eine verbesserte Schaltungsanordnung zur Kompensation einer in einer Antennensignalverbindung zwischen einem Mobilfunkendgerät und einer Antenne auftretenden Dämpfung sowie ein Kompensationsverfahren hierzu zu schaffen, mit dem auf einfache Weise ohne Zugriff auf Information des Mobilfunkendgerätes und ohne aufwendige Vermessung der tatsächlich aktuell vorhandenen Koppeldämpfung eine an den Betriebszustand angepasste Einstellung des Verstärkungsfaktors des mindestens einen Antennensignalverstärkers erfolgt.

Die Aufgabe wird durch die Schaltungsanordnung mit den Merkmalen des Anspruchs 1 sowie durch das Kompensationsverfahren mit den Merkmalen des Anspruchs 11 gelöst. Vorteilhafte Ausführungsformen sind in den Unteransprüchen beschrieben.

Es wird vorgeschlagen, dass die Steuereinheit der Schaltungsanordnung zum Verändern des Verstärkungsfaktors, zum Erkennen einer als Reaktion hierauf durch Änderung der Sendeleistung des Mobilfunkendgerätes, d.h. der durch eine dann wirksam einsetzende Leistungsregelung des Mobilfunkendgerätes folgende Änderung der Antennensignalleistung, und zum Anpassen des Verstärkungsfaktors an die Koppeldämpfung der Antennensignalverbindung in Abhängigkeit einer erkannten Reaktion des Mobilfunkendgerätes eingerichtet ist.

So ist bspw. keine Anpassung des Verstärkungsfaktors notwendig, wenn die Sendesignalleistung des Mobilfunkendgerätes auf eine testweise durchgeführte Änderung des Verstärkungsfaktors reagiert und im Ergebnis die Antennensignalleistung des Kompensators damit unverändert bleibt. Dies ist dann ein Hinweis darauf, dass die netzseitige Leistungsregelung den Ausgleich der Koppeldämpfung vornehmen kann und damit ein guter Empfang vorliegt.

Wenn hingegen sich die Sendesignalleistung des Mobilfunkendgerätes bei einer Veränderung des Verstärkungsfaktors nicht ändert, dann greift die netzseitige Leistungsregelung des Mobilfunkendgerätes durch die damit verbundene Basisstation nicht mehr. Dies ist gleichbedeutend damit, dass das Mobiltelefon die maximale Sendeleistung erreicht hat. Dies gilt insbesondere, wenn das Mobilfunkendgerät mit der maximalen Sendeleistung sendet. Dann wird aber die erfasste Antennensignalleistung sich entsprechend der Änderung des Verstärkungsfaktors verändern, da sie nicht mehr durch eine Reaktion der Leistungsregelung des Mobilfunkendgerätes beeinflusst ist. Das Ausbleiben einer Reaktion des Mobilfunkendgeräts führt somit zu einer erfassbaren Reaktion der Antennensignalleistung des Antennensignals, insbesondere der Ausgangssignalleistung der Schaltungsanordnung, die von der Detektionseinheit erfasst wird. Wenn eine solche Reaktion erkannt wird, dann ermöglicht dies eine Anpassung des Verstärkungsfaktors so, dass ein Ausgleich der Koppeldämpfung erfolgt. Hierbei ist z.B. eine Differenz zwischen der vorgegebenen maximalen Antennensignalleistung und der Antennensignalleistung, die vor der Veränderung des Verstärkungsfaktors erfasst wurde, durch entsprechende Änderung des Verstärkungsfaktors auszugleichen.

Die Steuereinheit kann hierbei zur weiteren Erhöhung des Verstärkungsfaktors eingerichtet sein, wenn durch Erfassen der Antennensignalleistung keine Änderung der Sendesignalleistung des Mobilfunkendgerätes als Reaktion auf eine testweise Erhöhung des Verstärkungsfaktors erkannt wird. Damit wird die Sendesignalleistung des Mobilfunkendgerätes ausgewertet. In diesem Zustand wird dann die exakte Koppeldämpfung berechnet und die fehlende Verstärkung gesetzt, dass die Koppeldämpfung ausgeglichen wird, wodurch die Ausgangsleistung der Schaltungsanordnung somit der Ausgangsleistung des Mobilfunkendgerätes entspricht. Optional ist es aber auch möglich ohne Berechnung (ggf. durch Schätzung) der Koppeldämpfung den Verstärkungsfaktor schrittweise so weit zu erhöhen, bis die maximale Ausgangsleistung erreicht wird (langsame Annäherung). Dies ist der Fall, wenn sich die Ausgangssignalleistung der Schaltungsanordnung der bei Erhöhung des Verstärkungsfaktors gleichbleibenden Sendesignalleistung des Mobilfunkendgerätes annähert.

Die Steuereinheit kann zur Einstellung eines vorgegebenen minimalen Verstärkungsfaktors eingerichtet sein, wenn die erfasste Antennensignalleistung geringer als ein vorgegebener Schwellwert ist. Damit wird innerhalb eines durch den vorgegebenen Schwellwert bestimmten Bereichs ein Betrieb mit dem vorgegebenen minimalen Verstärkungsfaktor durchgeführt, bei dem die netzseitige Leistungsregelung zum Ausgleich von Koppeldämpfungen im Antennensignalpfad ausreichend ist. Erst wenn die erfasste Antennensignalleistung, wie bspw. die Ausgangssignalleistung der Kompensationsschaltungsanordnung und insbesondere die Ausgangssignalleistung des zur Antenne geführten Antennensignals des Antennensignalverstärkers dem Schwellwert entspricht oder diesen überschreitet, dann wird durch z.B. testweises Verändern des Verstärkungsfaktors anhand der hieraus resultierenden Reaktion entweder durch eine einsetzende Leistungsregelung des Mobilfunkendgerätes oder durch Ausbleiben der Leistungsregelung des Mobilfunkendgerätes entschieden, ob und in welchem Umfang eine Anpassung des Verstärkungsfaktors erfolgt. Für den Fall, dass die netzseitige Leistungsregelung nicht mehr wirksam werden kann, da das Mobilfunkendgerät seine maximal mögliche Sendesignalleistung erreicht hat, bleibt die erfasste Sendesignalleistung trotz Anpassung des Verstärkungsfaktors konstant. Dies ermöglicht dann, auf die tatsächlich vorhandene Koppeldämpfung im Antennensignalpfad auf Grundlage der erfassten Antennensignalleistung zu schließen.

Die Einstellung des Verstärkungsfaktors auf den vorgegebenen minimalen Verstärkungsfaktor Vₘᵢₙ kann prinzipiell unter folgenden, separat oder in Kombination auswählbaren Kriterien erfolgen:
a) generell bei einer Erkennung einer Änderung der Sendesignalleistung;
b) wenn die erfasste Antennensignalleistung geringer als ein vorgegebener Schwellwert ist, insbesondere vor der ersten Ermittlung des optimalen Verstärkungsfaktors Vₒₚₜ;
c) wenn die erfasste Antennensignalleistung nach der ersten Ermittlung des optimalen Verstärkungsfaktors Vₒₚₜ geringer als ein vorgegebener zweiter Schwellwert ist.

Die Steuereinheit kann zur Auswertung der Form der Antennensignalleistung eingerichtet sein, die sich als Reaktion auf eine Folge von testweise durchgeführten Änderungen des Verstärkungsfaktors ergibt. Wenn dann bspw. schrittweise in vorgegebenen Größen der Verstärkungsfaktor z.B. in Schritten von 1dB erhöht oder erniedrigt wird, so lässt sich dieses Muster im erfassten Antennensignal anhand der Antennensignalleistung bspw. am Ausgang des Antennensignalverstärkers zur Antenne hin gleichermaßen wiederfinden, wenn die netzseitige Regelung des Mobilfunkendgerätes nicht wirksam ist. Damit kann anhand eines einfachen Mustervergleichs auf zuverlässige Weise festgestellt werden, ob eine Anpassung des Verstärkungsfaktors erforderlich ist.

Die Steuereinheit kann zur Änderung des Verstärkungsfaktors in einer Phase eingerichtet sein, in der die erfasste Sendesignalleistung des Mobilfunkendgerätes gleichbleibend ist. Dann ist die Steuereinheit eingerichtet, um einen zum Ausgleich der Differenz der dabei erfassten Antennensignalleistung des Antennensignalverstärkers und der Sendesignalleistung des Mobilfunkendgerätes geeigneten Verstärkungsfaktor auszuwählen. Die trotz Änderung des Verstärkungsfaktors gleichbleibende Sendesignalleistung des Mobilfunkendgerätes wird somit als Maß herangezogen, auf das dann die Sendesignalleistung am Ausgang des Antennensignalverstärkers durch Anpassung des Verstärkungsfaktors angehoben wird. Diese Differenz ist die noch fehlende Verstärkung der fest eingestellten minimalen Vorverstärkung (Vₘᵢₙ), um welche die Verstärkung erhöht werden muss, um eine exakte Kompensation der gesamten Dämpfung vom Mobilfunkgerät bis zur Fahrzeugantenne zu erhalten.

Die zum Ausgleich der tatsächlichen Koppeldämpfung notwendige Anpassung des Verstärkungsfaktors kann somit sehr einfach aus dem erfassten Signalunterschied der Sendesignalleistung des Mobilfunkendgerätes und der Antennensignalleistung bestimmt werden, die sich auch durch die Änderung der Antennensignalausgangsleistung des Antennensignalverstärkers zur Antenne hin als Resultat der Änderung des Verstärkungsfaktors widerspiegelt. In diesem Fall wird davon ausgegangen, dass das Mobilfunkendgerät mit maximaler bekannter Sendeleistung betrieben wird.

Die Steuereinheit kann zur Detektion der von der Schaltungsanordnung über die Antenne empfangenen oder über die Antenne ausgestrahlten Antennensignalleistung, zur schrittweisen Änderung des Verstärkungsfaktors in einer Phase, in der die detektierte Antennensignalleistung gleichbleibend ist, und zur Ermittlung der Koppeldämpfung als Verhältnis oder Differenz der detektierten Antennensignalleistung und einer vorgegebenen maximalen Antennensignalleistung eingerichtet sein, wenn die schrittweise Änderung des Verstärkungsfaktors zu keiner Änderung der detektierten Antennensignalleistung oder der detektierten Sendesignalleistung des Mobilfunkendgerätes führt.

Die noch fehlende Verstärkung der fest eingestellten minimalen Vorverstärkung (Vₘᵢₙ), um welche die Verstärkung erhöht werden muss, um eine exakte Kompensation der gesamten Dämpfung vom Mobilfunkgerät bis zur Fahrzeugantenne zu erhalten (d.h. der noch auszugleichende Koppeldämpfungsanteil), entspricht nämlich dem Quotienten bzw. der Differenz zwischen der vor der Änderung des Verstärkungsfaktors in der Phase, bei der die detektierte Antennensignalleistung gleichbleibend ist, erfassten Antennensignalleistung und der bekannten vorgegebenen maximalen Antennensignalleistung für den Fall, dass sich trotz Veränderung des Verstärkungsfaktors, insbesondere der Vergrößerung des Verstärkungsfaktors entweder die Antennensignalleistung am Ausgang des Antennensignalverstärkers oder durch fehlende Wirksamkeit der Leistungsregelung des Mobilfunkendgerätes die Sendesignalleistung des Mobilfunkendgerätes nicht ändert.

Die Schaltungsanordnung kann einen Datenspeicher zur Abspeicherung des angepassten Verstärkungsfaktors und eines vorgegebenen minimalen Verstärkungsfaktors haben. Die Steuereinheit ist so eingerichtet, um den im Datenspeicher abgespeicherten angepassten Verstärkungsfaktor und den minimalen Verstärkungsfaktor auszulesen um damit den Antennensignalverstärker anzusteuern. Dabei wird der Verstärkungsfaktor des Antennensignalverstärkers in der Regel durch die Steuereinheit auf den ausgelesenen minimalen Verstärkungsfaktor eingestellt, wenn die netzseitige Leistungsregelung des Mobilfunkendgerätes funktionsfähig ist. Ansonsten erfolgt die Ansteuerung des Antennensignalverstärkers durch den angepassten Verstärkungsfaktor. Dies kann zumindest solange mit dem angepassten Verstärkungsfaktor erfolgen, bis eine neue Anpassung des Verstärkungsfaktors erforderlich ist.

Die Steuereinheit kann zur Einstellung des Antennensignalverstärkers mit dem angepassten Verstärkungsfaktor solange eingerichtet sein, bis eine maximale Sendesignalleistung des Mobilfunkendgerätes erkannt wird. Bei Erkennung eines Betriebs bei maximaler Sendesignalleistung des Mobilfunkendgerätes erfolgt in der vorher beschriebenen Weise eine erneute Anpassung des Verstärkungsfaktors. Hierzu kann dann wieder eine testweise Änderung des Verstärkungsfaktors wie bspw. ein testweise schrittweises Erhöhen des Verstärkungsfaktors und eine Auswertung der hierauf erfolgenden Reaktion erfolgen.

Die Erfindung wird nachfolgend anhand eines Ausführungsbeispiels mit den beigefügten Zeichnungen näher erläutert. Es zeigen:
- Figur 1: - Skizze eines Funksystems mit einer Basisstation und einer in einem Kraftfahrzeug eingebauten Kompensationsschaltungsanordnung zwischen einer Antenne und einem Mobilfunkendgerät;
- Figur 2: - Blockdiagramm einer Ausführungsform einer Kompensationsschaltungsanordnung;
- Figur 3: - Diagramm der Signalleistungen des Mobilfunkendgerätes und des Antennensignalverstärkers sowie des Verstärkungsfaktors über die Zeit in einem Leistungsbereich;
- Figur 4: - Diagramm aus Figur 3 mit Antennensignalleistung des Antennensignalverstärkers im Sättigungsbereich;
- Figur 5: - Diagramm nach Figur 3 und 4 mit Sendeleistung des Mobilfunkendgerätes im Sättigungsbereich;
- Figur 6: - Diagramm aus Figur 5 mit weiterer Nutzung eines angepassten Verstärkungsfaktors.

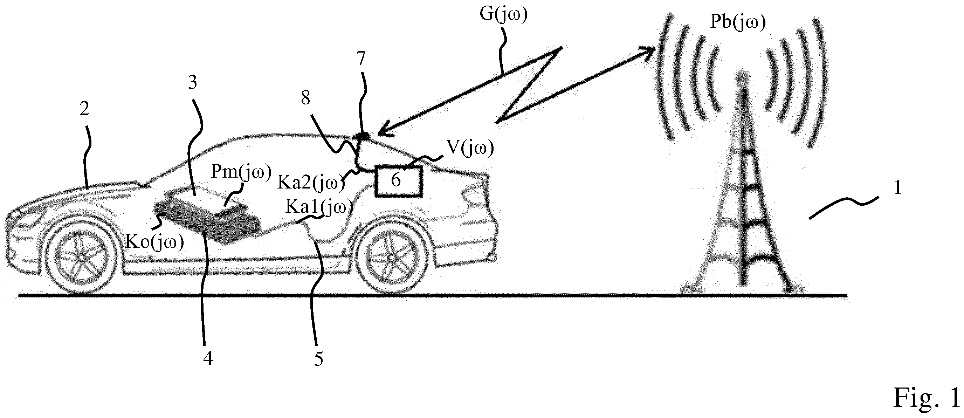

Figur 1 lässt eine Skizze eines Mobilfunksystems mit einer Basisstation 1 und einem in einem Kraftfahrzeug 2 betriebenen Mobilfunkendgerät 3 erkennen. In dem Kraftfahrzeug 2 ist eine Koppelschale 4 zur Aufnahme des Mobilfunkendgerätes 3 eingebaut, die über eine Antennensignalverbindung 5 mit einer Schaltungsanordnung 6 zur Kompensation der in der Antennensignalverbindung 5 zwischen Mobilfunkendgerät 3 und einer Antenne 7 am Fahrzeug 2 auftretenden Koppeldämpfung eingerichtet ist. Hierzu hat die Kompensationsschaltungsanordnung 6 einen Antennensignalverstärker.

In dem Signalpfad zwischen Basisstation 1 und Mobilfunkendgerät 3 treten folgende Leistungen und Verluste auf:
Das Mobilfunkendgerät 3 sendet zunächst ein elektromagnetisches Funksignal mit der Sendeleistung Pm(jω). Nun treten Koppelverluste Ko(jω) durch die Ankopplung zwischen Mobilfunkendgerät 3 und Koppelschale 4 auf. In der Antennensignalverbindung 5 zwischen Koppelschale 4 und Kompensationsschaltungsanordnung 6 treten weitere Kabelverluste Ka1(jω) auf.

Die Kompensationsschaltungsanordnung 6 führt zu einer Signalverstärkung V(jω). In der Antennensignalverbindung 8 zwischen Kompensationsschaltungsanordnung 6 und Antenne 7 tritt ein weiterer Kabelverlust Ka2(jω) auf.

In dem Signalpfad zwischen Antenne 7 des Kraftfahrzeuges 2 und der Basisstation 1 ist ein Übertragungsverlust G(jω) vorhanden. Die von der Basisstation 1 letztendlich empfangene Signalleistung Pb(jω) ist somit nicht nur von der Sendeleistung des Mobiltelefons 3, sondern durch die dazwischenliegenden Verluste und Verstärkungen bestimmt. Die von der Basisstation 1 empfangene Signalleistung Pb(jω) berechnet sich somit wie folgt:
Während die Kabelverluste Ka1(jω) und Ka2(jω) in einem Fahrzeug 2 in der Regel konstant sind, verändern sich die Verluste G(jω), V(jΩ) (kontrolliert) und Ko(jω) im Betrieb. Für kurze Zeiten im Bereich von weniger als 1 ms kann dabei angenommen werden, dass sich die Koppeldämpfung Ko(jω) und die Übertragungsverluste G(jω) nicht signifikant ändern und quasi konstant sind. Der Verstärkungsfaktor zur Einstellung der Verstärkung V(jω) ist hingegen ein auch in solchen kurzzeitigen Phasen gut regelbarer Parameter. Wenn dieser in solche kurze Zeiten geändert wird, beeinflusst dies die Ausgangsleistung des Mobilfunkendgerätes 3 messbar aufgrund der eintretenden Leistungsregelung des Mobilfunkendgerätes 3, die durch die Basisstation 1 gesteuert wird. Diese netzseitige Leistungsregelung (auch Close-Loop-Regulation genannt) tritt z.B. bei dem LTE-Kommunikationsstandard in einer Periodizität von 667 µs (1500 Hz) auf.

Es ist aus Figur 1 somit erkennbar, dass beim Anschluss eines Mobilfunkendgerätes 3 an eine externe Antenne 7 des Kraftfahrzeuges 2, wie dies bspw. bei Freisprecheinrichtungen in Kraftfahrzeugen 2 erfolgt, im Signalweg von Mobilfunkendgerät 3 zu Antenne 7 und umgekehrt eine Dämpfung auftritt. Obwohl durch die externe Antenne 7 die Sende- und Empfangsqualität verbessert werden soll, führt diese Dämpfung nicht zur möglichen erreichbaren Signalqualität. Bei einer elektromagnetischen, kapazitiven oder induktiven Kopplung des Mobilfunkendgerätes 3 mit dem Antennensignalverstärker der Kompensationsschaltungsanordnung 6 und der daran angeschlossenen Antenne 7 kann die Dämpfung in Abhängigkeit von dem aktuellen Betriebszustand, von dem verwendeten Mobilfunkendgerät 3 (und von der Position des Mobilfunkendgerätes 3) variieren. Dann ist ein vorgegebener konstanter Verstärkungsfaktor nicht optimal und kann besonders für Zonen mit schlechteren Empfangsbedingungen nicht die erforderliche Kompensation erreichen.

Die Kompensationsschaltungsanordnung 6 ist nun so eingerichtet, dass die zwischen Mobilfunkendgerät 3 und Antenne 7 auftretende Koppeldämpfung adaptiv fortlaufend durch Anpassung des Verstärkungsfaktors, d.h. der Verstärkung V(jω) ohne Zugriff auf Informationen des Mobilfunkendgerätes 3, d.h. ohne Datenanalyse, anhand einer einfachen fortlaufenden Antennensignalleistungsmessung (Pegel-Detektion) und einer Initialisierungssequenz an die tatsächlich aktuell in der Antennensignalverbindung vorhandene Koppeldämpfung und damit einen Betriebszustand angepasst wird.

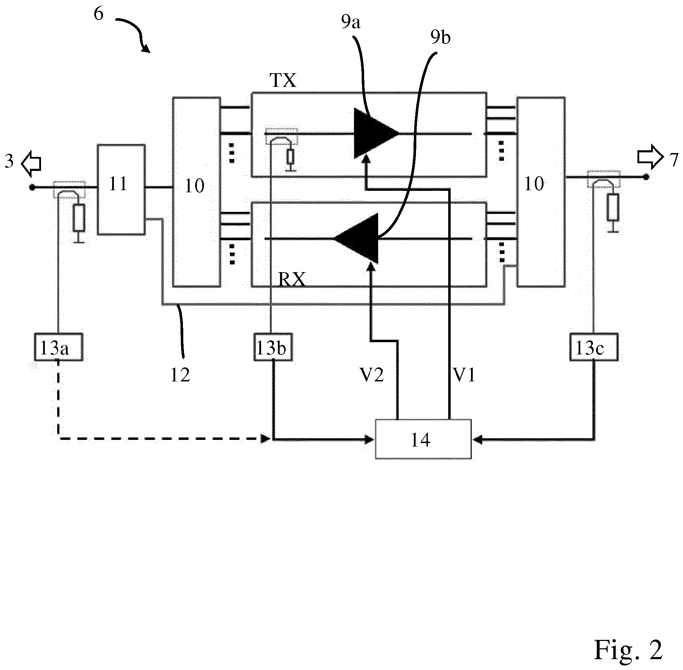

Figur 2 lässt ein Blockdiagramm der Kompensationsschaltungsanordnung 6 erkennen. Die Kompensationsschaltungsanordnung 6 hat einen ersten Antennensignalverstärker 9a für das vom Mobilfunkendgerät 3 an die Antenne 7 übertragenes Sendesignal und einen zweiten Antennensignalverstärker 9b für das über die Antenne 7 von der Basisstation 1 empfangene und an das Mobilfunkendgerät 3 weitergeleitete Empfangssignal. Zur Umschaltung zwischen dem Sendepfad TX und dem Empfangspfad RX der Antennensignalverstärker 9a, 9b sind Schalter und/oder Filterelemente 10 vorhanden. Es kann ein weiterer Schalter 11 für eine Bypass-Verbindung 12 vorgesehen sein, um ein Signal ohne weitere Verstärkung durchzuleiten. Dies ist wie auch die Auswahl der Anzahl der Antennensignalverstärker 9a, 9b gegebenenfalls gesondert für einzelne Frequenzbänder optional. So kann z.B. für jedes Mobilfunksystem GSM, CDMA/LTE und gegebenenfalls für verschiedene Frequenzbänder wie bspw. 800 MHz, 900 MHz, 1800 MHz, 1900 MHz, 2100 MHz und 2600 MHz eigene Antennensignalverstärker in hierfür vorgesehenen Signalzweigen vorgesehen sein.

Zur Messung der Signalleistungen kann bspw. am Eingang der Kompensationsschaltungsanordnung 6 zum Mobilfunkendgerät 3 hin eine erste Detektionseinheit 13a zur Ermittlung der dort auftretenden Sendesignalleistung des Mobilfunkendgerätes, im Sendepfad TX eingangsseitig eine zweite Detektionseinheit 13b zur Detektion des aktiven Bandes und am Ausgang des Kompensationsschaltungsanordnung 6 zur Antenne 7 hin eine dritte Detektionseinheit 13c vorhanden sein. Mit diesen Detektionseinheiten 13a, 13b, 13c wird die dort vorliegende Signalleistung erfasst und an eine Steuereinheit 14 übertragen. Die Steuereinheit 14 bestimmt nun einen jeweiligen Verstärkungsfaktor V1, V2, mit dem die von der Steuereinheit 14 ermittelte aktuelle Koppeldämpfung für den Sendepfad TX und den Empfangspfad RX ausgeglichen. Es ist zu erkennen, dass ggf. mehrere Detektionseinheiten der ersten, zweiten und dritten Art, d.h. der Detektionseinheiten 13a, 13b, 13c für jedes vorgesehene Frequenzband vorhanden sein können. Die ersten, zweiten und/oder dritten Detektionseinheiten 13a, 13b, 13c können zur Messung der Signalleistungen in mehreren Frequenzbändern aber auch optional jeweils als eine Einheit zur Detektion der in auswählbaren Frequenzbändern vorliegenden Signalpegel ausgebildet sein.

Mit Hilfe der Steuereinheit 14 wird somit dem systembedingt vorhandenen Regelkreis, d.h. der netzseitigen Leistungsregelung zwischen Mobilfunkendgerät 3 und Basisstation 1 eine weitere Einstellung des Verstärkungsfaktors V1, V2 des mindestens einen zugeordneten Antennensignalverstärkers 9a, 9b überlagert. Die netzseitige Leistungsregelung wird durch einen Antennensignalleistungs-Regelkreis zwischen dem angekoppelten Mobilfunkendgerät 3 und der damit verbundenen Basisstation 1 eines Mobilfunknetzes bestimmt, mit dem das Mobilfunkendgerät 3 in Kommunikationsverbindung steht. Mit dieser netzseitigen Leistungsregelung wird durch die Vorgaben des Kommunikationsstandards eine Regelung der Sendeleistung des Mobilfunkendgerätes 3 vorgenommen.

Für die Dämpfungskompensation ist die Steuereinheit 14 nun in der nachfolgend beschriebenen Weise z.B. durch geeignete Programmierung eingerichtet.

Es wird davon ausgegangen, dass unterhalb eines bestimmten Grenzwertes P_{grenz} für die erfasste Antennensignalleistung der Empfang ausreichend genug ist und die ohnehin vorhandene primäre netzseitige Leistungsregelung des Mobilfunkendgerätes 3 den Betrieb in einem zulässigen Leistungsbereich sicherstellt. Durch die netzseitige Leistungsregelung wird somit eine Koppeldämpfung automatisch und vollständig ausgeglichen.

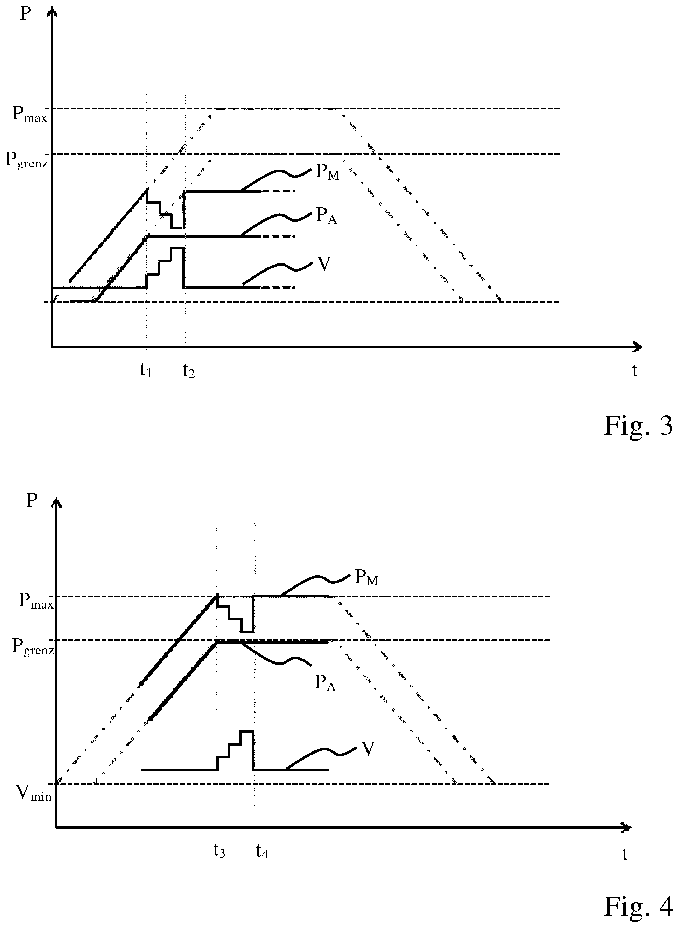

Dieser Betriebsbereich ist in dem Diagramm in Figur 3 skizziert. Dort ist die Signalleistung P über der Zeit t für die Sendesignalleistung P_{M} des Mobilfunkendgerätes 3 und die Antennensignalleistung P_{A} am Ausgang der Kompensationsschaltungsanordnung, d.h. die Kompensator-Ausgangsleistung dargestellt. Ferner ist die Kompensator-Verstärkung, d.h. der Verstärkungsfaktor V des Antennensignalverstärkers über die Zeit t aufgetragen. Für diesen Einstellbereich ist nun ein minimaler Verstärkungsfaktor Vₘᵢₙ so festgelegt, dass die Verstärkung bei einer angenommenen geringsten Koppeldämpfung diese exakt ausgleicht. Anhand der gestrichelten weitergeführten Linien ist angedeutet, dass die Steuereinheit 14 optional so eingerichtet ist, dass sie den vorgegebenen minimalen Verstärkungsfaktor Vₘᵢₙ dann einstellt, wenn die erfasste Antennensignalleistung P_{A} geringer als der vorgegebene Grenzwert P_{grenz} ist. Dies führt dazu, dass die Sendeleistung P_{M} des Mobilfunkendgerätes 3 immer innerhalb der zulässigen Grenze bis zur vorgegebenen maximalen Sendeleistung Pₘₐₓ liegt.

Es ist nun weiter zu erkennen, dass die Steuereinheit 14 zur testweisen Anpassung des Verstärkungsfaktors V bspw. in Schritten vorgegebener Dämpfung, z.B. in 1dB-Schritten eingerichtet ist. So kann der Verstärkungsfaktor V z.B. in mehreren 1dB-Schritten hintereinander erhöht werden. Dies führt durch die wirksame netzseitige Leistungsregelung dazu, dass die Sendeleistung P_{M} des Mobilfunkendgerätes 3 entsprechend reduziert wird, um die vorgegebene Antennensignalleistung P_{A} konstant zu halten. In der kurzen Mess- und Testzeit ist davon auszugehen, dass die Umwelteinflüsse als quasikonstant angenommen werden können.

In Figur 4 (Grenzfall) ist anhand des Diagramms beim Betrieb des Mobilfunkendgerätes 3 oberhalb des vorgegebenen Grenzwertes P_{grenz} deutlich, dass die netzseitige Leistungsregelung immer noch bei Erhöhung des Verstärkungsfaktors V testweise in den Schritten im Zeitintervall zwischen t3 und t4 dafür sorgt, dass die Antennensignalleistung P_{A} am Ausgang der Kompensationsschaltungsanordnung 6 konstant gehalten wird.

Durch eine testweise Erhöhung des Verstärkungsfaktors V bspw. in mehreren Schritten hintereinander ist somit im Normalbetrieb bei funktionsfähiger netzseitiger Leistungsregelung, mit der die tatsächliche Koppeldämpfung immer noch vollständig ausgeglichen werden kann, ein entsprechendes Muster der Sendeleistung P_{M} des Mobilfunkendgerätes 3 zu erkennen, das gegenläufig hierzu ist.

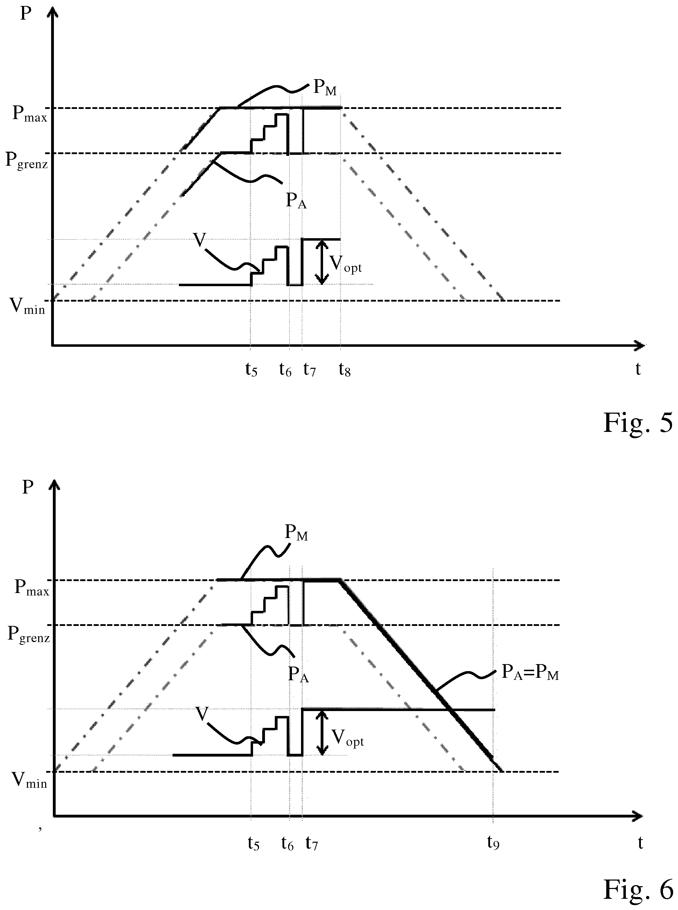

Figur 5 lässt nun ein Diagramm der Antennensignalleistung P über die Zeit t erkennen, bei dem die Sendeleistung P_{M} des Mobilfunkendgerätes 3 bei einer testweisen Erhöhung des Verstärkungsfaktors V konstant auf dem Wert der maximalen Sendeleistung Pₘₐₓ bleibt. Damit wird deutlich, dass oberhalb eines bestimmten Grenzwertes für die erfasste Antennensignalleistung P, d.h. bei einem schlechteren Empfang, die netzseitige Leistungsregelung nach und nach in den maximalen Sendeleistungsbereich Pₘₐₓ übergeht. Bei der Kommunikation nach dem LTE-Standard wäre dies bei 24dBm der Fall. Während bei einer Situation gemäß Figur 4 die mit einer Periodizität von 667 µs (1500 Hz) wirkende netzseitige Leistungsregelung bei der schrittweisen Änderung des Verstärkungsfaktors V in vergleichbar damit größeren Zeitintervallen wirken kann, zeigt sich bei Erreichung der maximalen Sendeleistung wie in Figur 5 ein unverändert konstanter Wert der Sendeleistung P_{M} des Mobilfunkendgerätes 3. Trotz Erhöhung des Verstärkungsfaktors V reicht die Sendeleistung P_{M} des Mobilfunkendgerätes 3 noch nicht aus, um die Koppeldämpfung vollständig auszugleichen. Diese Situation ist nicht nur dadurch erkennbar, dass die Sendeleistung P_{M} des Mobilfunkendgerätes 3 trotz testweiser Erhöhung des Verstärkungsfaktors V konstant bleibt. Es findet sich an der Ausgangsleistung P_{A} der Kompensationsschaltungsanordnung 6 auch eine entsprechende schrittweise Erhöhung, die dem Muster der testweisen Änderung des Verstärkungsfaktors V direkt folgt. Es kann somit nicht nur die Erreichung der maximalen Sendeleistung Pₘₐₓ durch das Sendesignal des Mobilfunkendgerätes 3 genutzt werden, um zu erkennen wann das Mobilfunkendgerät 3 mit maximaler Sendeleistung sendet, um dann mittels der erfassten Antennensignalleistung P_{A} auf die exakte Koppeldämpfung schließen zu können. Vielmehr wird nach Feststellung einer unveränderten erfassten Antennensignalleistung P_{A} die Verstärkung testweise in Schritten erhöht oder gegebenenfalls reduziert und die Reaktion des Mobilfunkendgerätes 3 beobachtet. Falls erkennbar ist, dass die netzseitige Leistungsregelung einsetzt, ist das gleichbedeutend damit, dass ein ausreichend guter Empfang mit der minimalen Verstärkung Vₘᵢₙ gegeben ist und die primäre netzseitige Leistungsregelung eine sichere Verbindung mit Ausgleich der aktuell vorhandenen Koppeldämpfung sicherstellt.

Für den Fall, dass die Sendeleistung P_{M} des Mobilfunkendgerätes 3 trotz Veränderung der Verstärkung V immer noch konstant ist, kann davon ausgegangen werden, dass das Mobilfunkendgerät 3 tatsächlich mit maximaler Sendeleistung sendet. Die Differenz zwischen dem gemessenen Eingangsleistungswert der Schaltungsanordnung 6 und der dann angenommenen maximalen Sendeleistung Pₘₐₓ des Mobilfunkendgerätes 3 ist durch die Koppeldämpfung und Kabeldämpfung verursacht. Es kann zur Einstellung der optimalen Verstärkung genutzt werden, womit eine exakte Kompensation möglich wäre.

Dieser optimale Verstärkungsfaktor Vₒₚₜ kann mit Hilfe dieser Differenz bzw. des Quotienten berechnet oder aber auch testweise durch Erhöhung des Verstärkungsfaktors V ermittelt werden. Der optimale Verstärkungsfaktor wird dann vorzugsweise in einem Datenspeicher der Kompensationsschaltungsanordnung 6 abgelegt und von dieser zur Ansteuerung der Antennensignalverstärker 9a, 9b ausgelesen

Dieser abgespeicherte Wert Vₒₚₜ kann nun bis zur nächsten Berechnungsphase genutzt und beibehalten werden.

Dies ist anhand der Figur 6 skizziert. Erkennbar ist, dass hierdurch die Sendeleistung P_{M} des Mobilfunkendgerätes 3 und die Antennensignalleistung P_{A} am Kompensatorausgang übereinstimmen, da mit dem optimalen Verstärkungsfaktor Vₒₚₜ die tatsächliche Koppeldämpfung nahezu vollständig ausgeglichen ist. Wenn sich die Koppeldämpfung bspw. durch Verschiebung des Mobilfunkendgerätes 3 auf der Koppelschale 4 ändert, kann in der nächsten Berechnungsphase, d.h. wenn erkannt wird, dass das Mobilfunkendgerät 3 wieder mit maximaler Sendeleistung Pₘₐₓ sendet, der optimale Verstärkungsfaktor Vₒₚₜ ermittelt, abgespeichert und eingestellt werden. Damit ist sichergestellt, dass die primäre netzseitige Leistungsregelung durch Anpassung des Verstärkungsfaktors V unterstützt wird, ohne dass zwei Regelkreise gegeneinander wirken. Zudem ist sichergestellt, dass die Kompensationsschaltungsanordnung 6 eine Anpassung des Verstärkungsfaktors V auf die tatsächlich vorliegende Dämpfung im Antennensignalpfad adaptiert.

Die Detektionseinheit 13a, 13b, 13c ist in der Schaltungsanordnung 6 vorzugsweise signaltechnisch so realisiert, dass die Antennensignalleistung P_{A} am Ausgang der Schaltungsanordnung 6 mindestens eines zugeordneten Sendeverstärkers 9a, der zur Verstärkung eines vom Mobilfunkendgerät 3 ausgesendeten Antennensignals dient, erfasst wird. Die Erfassung der Antennensignalleistung P_{A} als Sendeleistung des Mobilfunkendgerätes 3 hat den Vorteil, dass diese Leistung des Sendesignals wesentlich höher als die Leistung des Empfangssignals im Empfangspfad RX ist. Die Änderung dieser Signalleistung lässt sich aus dem Rauschen des Antennensignals mit einer guten Korrelation zur Leistungsregelung des Antennensignalleistungs-Regelkreises zwischen Mobilfunkendgerät 3 und Basisstation 1, d.h. der netzseitigen Leistungsregelung detektieren und als zur Adaption des Verstärkungsfaktors V herangezogene Größe nutzen.

Die Steuereinheit 14 kann dann zur Anpassung des Verstärkungsfaktors V1 mindestens eines Sendeverstärkers 9a eingerichtet sein, der zur Verstärkung eines von dem Mobilfunkendgerät 3 ausgesendeten Antennensignals dient. Eine Einstellung mindestens eines zugeordneten Empfangsverstärkers 9b, der zur Verstärkung eines über die Antenne 7 z.B. von einer Basisstation 1 empfangenen Antennensignals dient, kann dann in Abhängigkeit von dem angepassten Verstärkungsfaktor V1 des zugeordneten Sendeverstärkers 9a erfolgen. Der Verstärkungsfaktor V2 für die Empfangsverstärker 9b wird somit z.B. proportional mit einem festgelegten Faktor zum Verstärkungsfaktor V1 festgelegt. Die Adaption der Verstärkung V des Kompensators erfolgt somit vorzugsweise auf Basis des Sendesignals eines angeschlossenen Mobilfunkendgerätes 3. Dieser angepasste Verstärkungsfaktor V1 wird dann unmittelbar oder proportional zur Einstellung des Empfangsverstärkungsfaktors V2 herangezogen.

Mit Hilfe der Erkennung der Reaktion auf eine Veränderung des Verstärkungsfaktors in der Antennensignalleistung kann auf einfache Weise sichergestellt werden, dass die tatsächliche Koppeldämpfung optimal kompensiert werden kann und sichergestellt wird, dass bei einer höchsten Sendeleistung des Mobilfunkendgerätes 3 die Antennensignalleistung P_{A} am Antennenfußpunkt einen vorgegebenen oberen Grenzwert Pₘₐₓ nicht überschreitet.

## Patentansprüche

1. Schaltungsanordnung (6) zur Kompensation einer in einer Antennensignalverbindung zwischen einem Mobilfunkendgerät (3) und einer Antenne (7) auftretenden Dämpfung mit mindestens einem Antennensignalverstärker (9a, 9b) in der Antennensignalverbindung und mit einer Steuereinheit (14) zur Einstellung eines Verstärkungsfaktors (V, V1, V2), um welchen das durch einen zugeordneten Antennensignalverstärker (9a, 9b) geführte Antennensignal verstärkt oder gedämpft wird, wobei die Schaltungsanordnung (6) mindestens eine Detektionseinheit (13a, 13b, 13c) zur Erfassung einer Antennensignalleistung (P_{M}, P_{A}) des Antennensignals im Signalpfad der Antennensignalverbindung hat, **dadurch gekennzeichnet, dass** die Steuereinheit (14)
- zum testweisen Verändern des Verstärkungsfaktors (V, V1, V2),
- zum Erkennen einer als Reaktion auf die testweise Veränderung des Verstärkungsfaktors (V, V1, V2) folgenden Änderung der Antennensignalleistung (P), die durch eine Änderung der Sendeleistung (P_{M}) des Mobilfunkendgerätes (3) verursacht ist, und
- zum Anpassen des Verstärkungsfaktors (V, V1, V2) an die Koppeldämpfung der Antennensignalverbindung in Abhängigkeit einer erkannten Reaktion des Mobilfunkendgerätes (3) eingerichtet ist.

2. Schaltungsanordnung (6) nach Anspruch 1, **dadurch gekennzeichnet, dass** die Steuereinheit (14) zur weiteren Erhöhung des Verstärkungsfaktors (V, V1, V2) eingerichtet ist, wenn durch Erfassen der Antennensignalleistung (P) keine Änderung der Sendesignalleistung (P_{M}) des Mobilfunkendgerätes (3) als Reaktion auf eine testweise Erhöhung des Verstärkungsfaktors (V, V1, V2) erkannt wird.

3. Schaltungsanordnung (6) nach Anspruch 1 oder 2, **dadurch gekennzeichnet, dass** die Steuereinheit (14) zur Einstellung eines vorgegebenen minimalen Verstärkungsfaktors (Vₘᵢₙ) eingerichtet ist, wenn die erfasste Antennensignalleistung (P) geringer als ein vorgegebener Schwellwert (P_{grenz}) ist.

4. Schaltungsanordnung (6) nach einem der vorhergehenden Ansprüche, **dadurch gekennzeichnet, dass** die Steuereinheit (14) zur Einstellung eines vorgegebenen minimalen Verstärkungsfaktors (Vₘᵢₙ) eingerichtet ist, wenn eine Änderung der erfassten Signalleistung (P) erkannt wird.

5. Schaltungsanordnung (6) nach einem der vorhergehenden Ansprüche, **dadurch gekennzeichnet, dass** die Steuereinheit (14) zur Einstellung eines vorgegebenen minimalen Verstärkungsfaktors (Vₘᵢₙ) eingerichtet ist, wenn die erfasste Antennensignalleistung (P) nach der ersten Ermittlung eines optimalen Verstärkungsfaktors (Vₒₚₜ) geringer ist, als ein vorgegebener zweiter Schwellwert (Pₘᵢₙ).

6. Schaltungsanordnung (6) nach einem der vorhergehenden Ansprüche, **dadurch gekennzeichnet, dass** die Steuereinheit (14) zur Auswertung der Form der mit der Detektionseinheit (13a, 13b, 13c) erfassten Antennensignalleistung (P) als Reaktion auf eine Folge von testweisen Änderungen des Verstärkungsfaktors (V, V1, V2) eingerichtet ist.

7. Schaltungsanordnung (6) nach einem der vorhergehenden Ansprüche, **dadurch gekennzeichnet, dass** die Steuereinheit (14) zur Änderung des Verstärkungsfaktors (V, V1, V2) in einer Phase, in der die erfasste Sendesignalleistung (P) des Mobilfunkendgerätes (3) gleichbleibend ist, auf einen zum Ausgleich der Differenz der dabei erfassten Antennensignalleistung (P_{A}) des Antennensignalverstärkers (9a, 9b) und der Sendesignalleistung (P_{M}) des Mobilfunkendgerätes (3) geeigneten Verstärkungsfaktor (Vₒₚₜ) eingerichtet ist.

8. Schaltungsanordnung (6) nach einem der vorhergehenden Ansprüche, **dadurch gekennzeichnet, dass** die Steuereinheit (14) zur Detektion der von der Steuereinheit (14) über die Antenne (7) empfangenen oder über die Antenne (7) ausgestrahlten Antennensignalleistung (P), zur schrittweisen Änderung des Verstärkungsfaktors (V, V1, V2) in einer Phase, in der die detektierte Antennensignalleistung (P) gleichbleibend ist, und zur Ermittlung der Koppeldämpfung in Abhängigkeit von der detektierten Antennensignalleistung (P) eingerichtet ist, wenn die schrittweise Änderung des Verstärkungsfaktors (V, V1, V2) zu keiner Änderung der detektierten Antennensignalleistung (P) führt.

9. Schaltungsanordnung (6) nach einem der vorhergehenden Ansprüche, **dadurch gekennzeichnet, dass** die Schaltungsanordnung (6) einen Datenspeicher zur Abspeicherung des angepassten Verstärkungsfaktors (Vₒₚₜ) und eines vorgegebenen minimalen Verstärkungsfaktors (Vₘᵢₙ) hat.

10. Schaltungsanordnung (6) nach einem der vorhergehenden Ansprüche, **dadurch gekennzeichnet, dass** die Steuereinheit (14) zur Einstellung des Antennensignalverstärkers (9a, 9b) mit dem angepassten Verstärkungsfaktor (Vₒₚₜ) solange eingerichtet ist, bis eine maximale Sendesignalleistung (Pₘₐₓ) des Mobilfunkendgerätes (3) erkannt wird, und bei Erkennung eines Betriebs bei maximaler Sendesignalleistung (Pₘₐₓ) des Mobilfunkendgerätes (3) eine erneute Anpassung des Verstärkungsfaktors (V) erfolgt.

11. Verfahren zur Kompensation einer in einer Antennensignalverbindung zwischen einem Mobilfunkendgerät (3) und einer Antenne (7) auftretenden Dämpfung mit Hilfe mindestens eines Signalverstärkers (9a, 9b) in der Antennensignalverbindung mit den Schritten:
- Erfassen einer Antennensignalleistung (P) des Antennensignals im Signalpfad der Antennensignalverbindung,
**gekennzeichnet durch**
- testweises Verändern des Verstärkungsfaktors (V, V1, V2),
- Erkennen, ob sich die Antennensignalleistung (P) als Reaktion auf die testweise Veränderung des Verstärkungsfaktors (V, V1, V2) durch eine Leistungsregelung des Mobilfunkendgerätes (3) ändert,
- Anpassen des Verstärkungsfaktors (V, V1, V2) an die Koppeldämpfung der Antennensignalverbindung in Abhängigkeit von einer erkannten Änderung der Antennensignalleistung (P) als Reaktion der Leistungsregelung des Mobilfunkendgerätes (3).

12. Verfahren nach Anspruch 11, **gekennzeichnet durch** weiteres Erhöhen des Verstärkungsfaktors (V), wenn durch Erfassen der Antennensignalleistung (P) keine Änderung der Sendesignalleistung des Mobilfunkendgerätes (3) als Reaktion auf eine testweise Erhöhung des Verstärkungsfaktors (V) erkannt wird.

13. Verfahren nach Anspruch 11, **gekennzeichnet durch** weiteres Verringern des Verstärkungsfaktors (V), wenn durch Erfassen der Antennensignalleistung (P) keine Änderung der Sendesignalleistung des Mobilfunkendgerätes (3) als Reaktion auf eine testweise Erhöhung des Verstärkungsfaktors (V) erkannt wird.

14. Verfahren nach Anspruch 11, 12 oder 13, **gekennzeichnet durch** Einstellen eines vorgegebenen minimalen Verstärkungsfaktors (Vₘᵢₙ), wenn die erfasste Antennensignalleistung (P) geringer als ein vorgegebener Schwellwert (P_{grenz}) ist.

15. Verfahren nach Anspruch 11, 12 oder 13, **gekennzeichnet durch** Einstellen eines vorgegebenen minimalen Verstärkungsfaktors (Vₘᵢₙ), wenn eine Änderung der empfangenen Sendeleistung detektiert wird.

16. Verfahren nach einem der Ansprüche 11 bis 15, **gekennzeichnet durch** Auswerten der Form der Antennensignalleistung (P), die sich als Reaktion auf eine Folge von testweisen Änderungen des Verstärkungsfaktors (V) ergibt.

17. Verfahren nach einem der Ansprüche 11 bis 16, **gekennzeichnet durch** schrittweises Ändern des Verstärkungsfaktors (V) und Beibehalten des Verstärkungsfaktors (V) über ein Zeitintervall, das größer als die Regelzeit einer Leistungsregelung des Mobilfunkendgerätes (3) durch Regelsignale einer Basisstation (1) ist.

18. Verfahren nach einem der Ansprüche 11 bis 17, **gekennzeichnet durch** Ändern des Verstärkungsfaktors (V, V1, V2) in einer Phase, in der die erfasste Sendesignalleistung (P_{M}) des Mobilfunkendgerätes (3) gleichbleibend ist, auf einen zum Ausgleich der Differenz der dabei erfassten Antennensignalleistung (P_{A}) des Antennensignalverstärkers (9a, 9b) und der Sendeleistung (P_{M}) des Mobilfunkendgerätes (3) geeigneten Verstärkungsfaktor (Vₒₚₜ).

19. Verfahren nach einem der Ansprüche 11 bis 18, **gekennzeichnet durch** Detektieren der über die Antenne (7) empfangenen oder über die Antenne (7) ausgestrahlten Antennensignalleistung (P), schrittweises Ändern des Verstärkungsfaktors (V, V1, V2) in einer Phase, in der die detektierte Antennensignalleistung (P) gleichbleibend ist, und Ermitteln der Koppeldämpfung in Abhängigkeit von der detektierten Antennensignalleistung (P), wenn die schrittweise Änderung des Verstärkungsfaktors (V, V1, V2) zu keiner Änderung der detektierten Antennensignalleistung (P) führt.

## Claims

1. Circuit arrangement (6) for compensating for an attenuation occurring in an antenna signal link between a mobile radio terminal (3) and an antenna (7) comprising at least one antenna signal amplifier (9a, 9b) in the antenna signal link and having a control unit (14) for adjusting a gain factor (V, V1, V2), by which the antenna signal conducted through an associated antenna signal amplifier (9a, 9b) is amplified or attenuated, wherein the circuit arrangement (6) has at least one detection unit (13a, 13b, 13c) for detecting an antenna signal power (PM, PA) of the antenna signal in the signal path of the antenna signal link, **characterized in that** the control unit (14)
- is configured for changing the gain factor (V, V1, V2) for testing purposes,
- for detecting a change, following as response to the test-wise change of the gain factor (V, V1, V2), of the antenna signal power (P), which is caused by a change of the transmit power (PM) of the mobile radio terminal (3), and
- for adapting the gain factor (V, V1, V2) to the coupling attenuation of the antenna signal link in dependence on a detected response of the mobile radio terminal (3).

2. Circuit arrangement (6) according to Claim 1, **characterized in that** the control unit (14) is configured for a further increase in the gain factor (V, V1, V2) if, by detecting the antenna signal power (P), no change of the transmit signal power (PM) of the mobile radio terminal (3) as response to a test-wise increase in the gain factor (V, V1, V2) is detected.

3. Circuit arrangement (6) according to Claim 1 or 2, **characterized in that** the control unit (14) is configured for adjusting a predetermined minimum gain factor (Vₘᵢₙ) if the detected antenna signal power (P) is less than a predetermined threshold value (Pₗᵢₘᵢₜ).

4. Circuit arrangement (6) according to one of the preceding claims, **characterized in that** the control unit (14) is configured for adjusting a predetermined minimum gain factor (Vₘᵢₙ) when a change in the detected signal power (P) is detected.

5. Circuit arrangement (6) according to one of the preceding claims, **characterized in that** the control unit (14) is configured for adjusting a predetermined minimum gain factor (Vₘᵢₙ) when the detected antenna signal power (P) is less than a predetermined second threshold value (Pₘᵢₙ) after the first determination of an optimal gain factor (Vₒₚₜ).

6. Circuit arrangement (6) according to one of the preceding claims, **characterized in that** the control unit (14) is configured for evaluating the form of the antenna signal power (P) detected with the detection unit (13a, 13b, 13c) in response to a sequence of test-wise changes of the gain factor (V, V1, V2).

7. Circuit arrangement (6) according to one of the preceding claims, **characterized in that** the control unit (14) is configured for changing the gain factor (V, V1, V2) in a phase in which the detected transmit signal power (P) of the mobile radio terminal (3) is constant, to a gain factor (Vₒₚₜ) suitable for compensating for the difference of the antenna signal power (P_{A}) detected during this process of the antenna signal amplifier (9a, 9b) and the transmit signal power (PM) of the mobile radio terminal (3).

8. Circuit arrangement (6) according to one of the preceding claims, **characterized in that** the control unit (14) is configured for the detection of the antenna signal power (P) received via the antenna (7) from the control unit (14) or radiated via the antenna (7) for the incremental change of the gain factor (V, V1, V2) in a phase in which the detected antenna signal power (P) is constant, and for determining the coupling attenuation in dependence on the detected antenna signal power (P) when the incremental change of the gain factor (V, V1, V2) does not lead to a change of the detected antenna signal power (P).

9. Circuit arrangement (6) according to one of the preceding claims, **characterized in that** the circuit arrangement (6) is configured with a data memory for storing the adapted gain factor (Vₒₚₜ) and a predetermined minimal gain factor (Vₘᵢₙ).

10. Circuit arrangement (6) according to one of the preceding claims, **characterized in that** the control unit (14) is configured for adjusting the antenna signal amplifier (9a, 9b) with the adapted gain factor (Vₒₚₜ) for as long until a maximum transmit signal power (Pₘₐₓ) of the mobile radio terminal (3) is detected and on detection of an operation at maximum transmit signal power (Pₘₐₓ) of the mobile radio terminal (3), a new adaptation of the gain factor (V) takes place.

11. Method for compensating for an attenuation occurring in an antenna signal link between a mobile radio terminal (3) and an antenna (7) with the aid of at least one signal amplifier (9a, 9b) in the antenna signal link comprising the steps:
- detecting an antenna signal power (P) of the antenna signal in the signal path of the antenna signal link,
**characterized by**
- changing the gain factor (V, V1, V2) for testing purposes,
- detecting if the antenna signal power (P) changes in response to the test-wise change of the gain factor (V, V1, V2) due to a power control of the mobile radio terminal (3),
- adapting the gain factor (V, V1, V2) to the coupling attenuation of the antenna signal link in dependence on a detected change in the antenna signal power (P) as response of the power control of the mobile radio terminal (3).

12. Method according to Claim 11, **characterized by** further increase of the gain factor (V) when due to detection of the antenna signal power (P) no change of the transmit signal power of the mobile radio terminal (3) as response to a test-wise increase in the gain factor (V) is detected.

13. Method according to Claim 11, **characterized by** further decrease of the gain factor (V) when due to detection of the antenna signal power (P) no change of the transmit signal power of the mobile radio terminal (3) as response to a test-wise increase in the gain factor (V) is detected.

14. Method according to Claim 11, 12 or 13, **characterized by** adjusting a predetermined minimum gain factor (Vₘᵢₙ) when the detected antenna signal power (P) is less than a predetermined threshold value (Pₗᵢₘᵢₜ).

15. Method according to one of claims 11, 12 or 13 **characterized by** adjusting a predetermined minimum gain factor (Vmin) when a change of the received transmit power is detected.

16. Method according to one of Claims 11 to 15, **characterized by** evaluating the form of the antenna signal power (P) which is obtained as response to a sequence of test-wise changes of the gain factor (V).

17. Method according to one of Claims 11 to 16, **characterized by** incremental changing of the gain factor (V) and retaining of the gain factor (V) over a time interval which is greater than the control time of a power control of the mobile radio terminal (3) through control signals of a base station (1).

18. Method according to one of Claims 11 to 17, **characterized by** changing the gain factor (V, V1, V2) in a phase in which the detected transmit signal power (P_{M}) of the mobile radio terminal (3) is constant to a gain factor (Vₒₚₜ) suitable for compensating for the difference of the antenna signal power (P_{A}) detected during this process of the antenna signal amplifier (9a, 9b) and the transmit power (P_{M}) of the mobile radio terminal (3).

19. Method according to one of Claims 11 to 18, **characterized by** detecting the antenna signal power (P) received via the antenna (7) or radiated via the antenna (7), incremental changing of the gain factor (V, V1, V2) in a phase in which the detected antenna signal power (P) is constant and determining the coupling attenuation in dependence on the detected antenna signal power (P) when the incremental change of the gain factor (V, V1, V2) does not lead to a change in the detected antenna signal power (P).

## Revendications

1. Arrangement de circuit (6) destiné à la compensation d'un affaiblissement qui se produit dans une liaison de signal d'antenne entre un terminal de radiocommunication mobile (3) et une antenne (7), comprenant au moins un amplificateur de signal d'antenne (9a, 9b) dans la liaison de signal d'antenne et comprenant une unité de commande (14) destinée à régler un facteur d'amplification (V, V1, V2) duquel le signal d'antenne qui passe à travers un amplificateur de signal d'antenne (9a, 9b) associé est amplifié ou atténué, l'arrangement de circuit (6) comportant au moins une unité de détection (13a, 13b, 13c) destinée à acquérir une puissance de signal d'antenne (P_{M}, P_{A}) du signal d'antenne dans le trajet de signal de la liaison de signal d'antenne, **caractérisé en ce que** l'unité de commande (14) est conçue
- pour modifier le facteur d'amplification (V, V1, V2) à titre d'essai,
- pour reconnaître une modification résultante de la puissance de signal d'antenne (P) en réaction à la modification du facteur d'amplification (V, V1, V2) à titre d'essai, laquelle est causée par une modification de la puissance d'émission (P_{M}) du terminal de radiocommunication mobile (3) et
- pour adapter le facteur d'amplification (V, V1, V2) à l'affaiblissement de couplage de la liaison de signal d'antenne en fonction d'une réaction reconnue du terminal de radiocommunication mobile (3).

2. Arrangement de circuit (6) selon la revendication 1, **caractérisé en ce que** l'unité de commande (14) est conçue pour augmenter davantage le facteur d'amplification (V, V1, V2) lorsque l'acquisition de la puissance de signal d'antenne (P) n'amène pas à reconnaître une modification de la puissance de signal d'émission (P_{M}) du terminal de radiocommunication mobile (3) en réaction à une augmentation du facteur d'amplification (V, V1, V2) à titre d'essai.

3. Arrangement de circuit (6) selon la revendication 1 ou 2, **caractérisé en ce que** l'unité de commande (14) est conçue pour régler un facteur d'amplification minimal (Vₘᵢₙ) prédéfini lorsque la puissance de signal d'antenne (P) acquise est inférieure à une valeur de seuil (P_{grenz}) prédéfinie.

4. Arrangement de circuit (6) selon l'une des revendications précédentes, **caractérisé en ce que** l'unité de commande (14) est conçue pour régler un facteur d'amplification minimal (Vₘᵢₙ) prédéfini lorsqu'une modification de la puissance de signal (P) acquise est reconnue.

5. Arrangement de circuit (6) selon l'une des revendications précédentes, **caractérisé en ce que** l'unité de commande (14) est conçue pour régler un facteur d'amplification minimal (Vₘᵢₙ) prédéfini lorsque la puissance de signal d'antenne (P) acquise, après la première détermination d'un facteur d'amplification optimal (Vₒₚₜ), est inférieure à une deuxième valeur de seuil (Pₘᵢₙ) prédéfinie.

6. Arrangement de circuit (6) selon l'une des revendications précédentes, **caractérisé en ce que** l'unité de commande (14) est conçue pour interpréter la forme de la puissance de signal d'antenne (P) acquise avec l'unité de détection (13a, 13b, 13c) en tant que réaction à une séquence de modifications à titre d'essai du facteur d'amplification (V, V1, V2).

7. Arrangement de circuit (6) selon l'une des revendications précédentes, **caractérisé en ce que** l'unité de commande (14) est conçue pour modifier le facteur d'amplification (V, V1, V2) dans une phase dans laquelle la puissance de signal d'antenne (P) acquise du terminal de radiocommunication mobile (3) est constante, à un facteur d'amplification (Vₒₚₜ) approprié pour compenser la différence entre la puissance de signal d'antenne (P_{A}) acquise ici de l'amplificateur de signal d'antenne (9a, 9b) et la puissance de signal d'émission (P_{M}) du terminal de radiocommunication mobile (3).

8. Arrangement de circuit (6) selon l'une des revendications précédentes, **caractérisé en ce que** l'unité de commande (14) est conçue pour détecter la puissance de signal d'antenne (P) reçue par l'unité de commande (14) par le biais de l'antenne (7) ou rayonnée par le biais de l'antenne (7), pour modifier par palier le facteur d'amplification (V, V1, V2) dans une phase dans laquelle la puissance de signal d'antenne (P) détectée est constante, et pour déterminer l'affaiblissement de couplage en fonction de la puissance de signal d'antenne (P) détectée lorsque la modification par palier du facteur d'amplification (V, V1, V2) ne donne lieu à aucune modification de la puissance de signal d'antenne (P) détectée.

9. Arrangement de circuit (6) selon l'une des revendications précédentes, **caractérisé en ce que** l'arrangement de circuit (6) comprend une mémoire de données destinée à mémoriser le facteur d'amplification (Vₒₚₜ) adapté et un facteur d'amplification minimal (Vₘᵢₙ) prédéfini.

10. Arrangement de circuit (6) selon l'une des revendications précédentes, **caractérisé en ce que** l'unité de commande (14) est conçue pour régler l'amplificateur de signal d'antenne (9a, 9b) avec le facteur d'amplification (Vₒₚₜ) adapté jusqu'à ce qu'une puissance de signal d'émission maximale (Pₘₐₓ) du terminal de radiocommunication mobile (3) soit reconnue et, en cas de reconnaissance d'un fonctionnement du terminal de radiocommunication mobile (3) à la puissance de signal d'émission maximale (Pₘₐₓ), une nouvelle adaptation du facteur d'amplification (V) est effectuée.

11. Procédé de compensation d'un affaiblissement qui se produit dans une liaison de signal d'antenne entre un terminal de radiocommunication mobile (3) et une antenne (7) à l'aide d'au moins un amplificateur de signal d'antenne (9a, 9b) dans la liaison de signal d'antenne, comprenant les étapes suivantes :
- l'acquisition d'une puissance de signal d'antenne (P) du signal d'antenne dans le trajet de signal de la liaison de signal d'antenne,
**caractérisé par**
- la modification du facteur d'amplification (V, V1, V2) à titre d'essai,
- le fait de détecter si la puissance de signal d'antenne (P) varie en réaction à la modification du facteur d'amplification (V, V1, V2) à titre d'essai par une régulation de puissance du terminal de radiocommunication mobile (3),
- l'adaptation du facteur d'amplification (V, V1, V2) à l'affaiblissement de couplage de la liaison de signal d'antenne en fonction d'une modification reconnue de la puissance de signal d'antenne (P) en réaction à la régulation de puissance du terminal de radiocommunication mobile (3).

12. Procédé selon la revendication 11, **caractérisé par** une augmentation supplémentaire du facteur d'amplification (V) lorsque l'acquisition de la puissance de signal d'antenne (P) n'amène pas à reconnaître une modification de la puissance de signal d'émission du terminal de radiocommunication mobile (3) en réaction à une augmentation du facteur d'amplification (V) à titre d'essai.

13. Procédé selon la revendication 11, **caractérisé par** une réduction supplémentaire du facteur d'amplification (V) lorsque l'acquisition de la puissance de signal d'antenne (P) n'amène pas à reconnaître une modification de la puissance de signal d'émission du terminal de radiocommunication mobile (3) en réaction à une augmentation du facteur d'amplification (V) à titre d'essai.

14. Procédé selon la revendication 11, 12 ou 13, **caractérisé par** le réglage d'un facteur d'amplification minimal (Vₘᵢₙ) prédéfini lorsque la puissance de signal d'antenne (P) acquise est inférieure à une valeur de seuil (P_{grenz}) prédéfinie.

15. Procédé selon la revendication 11, 12 ou 13, **caractérisé par** le réglage d'un facteur d'amplification minimal (Vₘᵢₙ) prédéfini lorsqu'une modification de la puissance d'émission reçue est détectée.

16. Procédé selon l'une des revendications 11 à 15, **caractérisé par** l'interprétation de la forme de la puissance de signal d'antenne (P) qui se produit en tant que réaction à une séquence de modifications à titre d'essai du facteur d'amplification (V).

17. Procédé selon l'une des revendications 11 à 16, **caractérisé par** une modification par palier du facteur d'amplification (V) et le maintien du facteur d'amplification (V) sur un intervalle de temps qui est supérieur au temps de régulation d'une régulation de puissance du terminal de radiocommunication mobile (3) par des signaux de régulation d'une station de base (1).

18. Procédé selon l'une des revendications 11 à 17, **caractérisé par** une modification du facteur d'amplification (V, V1, V2) dans une phase dans laquelle la puissance de signal d'émission (P_{M}) acquise du terminal de radiocommunication mobile (3) est constante à un facteur d'amplification (Vₒₚₜ) approprié pour compenser la différence entre la puissance de signal d'antenne (P_{A}) acquise ici de l'amplificateur de signal d'antenne (9a, 9b) et la puissance d'émission (P_{M}) du terminal de radiocommunication mobile (3).

19. Procédé selon l'une des revendications 11 à 18, **caractérisé par** la détection de la puissance de signal d'antenne (P) reçue par le biais de l'antenne (7) ou rayonnée par le biais de l'antenne (7), la modification par palier du facteur d'amplification (V, V1, V2) dans une phase dans laquelle la puissance de signal d'antenne (P) détectée est constante, et la détermination de l'affaiblissement de couplage en fonction de la puissance de signal d'antenne (P) détectée lorsque la modification par palier du facteur d'amplification (V, V1, V2) ne donne lieu à aucune modification de la puissance de signal d'antenne (P) détectée.
